Europäisches Patentamt

(19) European Patent Office

Office européen des brevets

(11) **EP 0 887 941 B1**

(12) **FASCICULE DE BREVET EUROPEEN**

(45) Date de publication et mention
de la délivrance du brevet:
**20.08.2003 Bulletin 2003/34**

(51) Int Cl.⁷: **H03M 7/00**, G06F 1/03

(21) Numéro de dépôt: **98401508.1**

(22) Date de dépôt: **19.06.1998**

(54) **Dispositif de génération de signaux analogiques à partir de convertisseurs analogique-numérique, notamment pour la synthèse numérique directe**

Anordnung zur Erzeugung von analogen Signalen unter Benutzung von Analog-Digitalwandlern, besonders für direkte digitale Synthese

Device generating analog signals using anolog-digital converters, in particular for direct digital synthesis

(84) Etats contractants désignés:
**DE ES FR GB IT NL SE**

(30) Priorité: **27.06.1997 FR 9708139**

(43) Date de publication de la demande:
**30.12.1998 Bulletin 1998/53**

(73) Titulaire: **Thales**
**75008 Paris (FR)**

(72) Inventeurs:
• **Gabet, Pascal,**
**THOMSON-CSF Propr. Intellectuelle**
**94117 Arcueil Cédex (FR)**

• **De Gouy, Jean-Luc,**
**THOMSON CSF. Propriété Int.**
**94117 Arcueil Cédex (FR)**

(56) Documents cités:
EP-A- 0 660 532      WO-A-91/04611
WO-A-96/17287      US-A- 5 574 455

• O'LEARY P ET AL: "AN OVERSAMPLING-BASED DTMF GENERATOR" IEEE TRANSACTIONS ON COMMUNICATIONS, vol. 39, no. 8, 1 août 1991, pages 1189-1191, XP000264283

**Description**

La présente invention concerne un dispositif de génération de signaux analogiques à partir de convertisseurs analogique-numérique. Elle s'applique notamment au domaine de la synthèse numérique directe. Plus généralement, elle s'applique à la génération de signaux analogiques à partir de convertisseurs numérique-analogique où il est par exemple nécessaire de réduire l'effet de non linéarité de ces derniers.

La synthèse numérique directe est une technique de synthèse de fréquence qui consiste à élaborer en numérique les échantillons du signal sinusoïdal que l'on veut générer et à convertir ces échantillons en analogique grâce à un convertisseur numérique-analogique, appelé CNA par la suite. Les synthétiseurs de fréquence obtenus par cette technique sont très attractifs en ce qui concerne leur volume, leur poids et leur consommation d'énergie car ils peuvent bénéficier d'une intégration importante. Leurs autres avantages sont notamment une très grande résolution et des temps de commutation très faibles.

Un inconvénient d'un synthétiseur numérique direct selon l'art antérieur est que le spectre du signal de sortie présente de nombreuses raies parasites. En effet, à l'entrée du CNA du synthétiseur, l'amplitude du signal est codé sur un nombre de bits M qui est en général plus faible que le nombre de bits N du signal numérique élaboré. Le passage de N bits à M bits génère une erreur de quantification ou de troncature qui se traduit par la présence de raies parasites sur le signal de sortie.

Par ailleurs, du fait de la quantification précitée, la fonction de transfert du CNA, c'est-à-dire la tension de sortie en fonction des mots numériques d'entrée, est une fonction en escalier. Les non-linéarités désignent alors le fait que les marches de l'escalier ne sont pas d'égales hauteurs. Ces non-linéarités s'ajoutent aux erreurs de quantification précitées, et sont donc des défauts de la fonction de transfert par rapport à une fonction de transfert idéale où les marches auraient la même hauteur. Les non-linéarités du CNA se traduisent par la génération de fréquences harmoniques qui sont repliées du fait de l'échantillonnage. En d'autres termes, des raies parasites sont ainsi crées, une raie parasite étant une composante spectrale située à des fréquences différentes de celle de la composante fondamentale du signal à synthétiser.

Une méthode connue pour éliminer la quantification d'amplitude et réduire les non-linéarités d'un CNA, est de sommer un bruit aléatoire de forte amplitude au signal numérique élaboré, présent à l'entrée du CNA. Ce bruit aléatoire est ensuite retranché de façon analogique par un deuxième CNA. Cette méthode est notamment décrite dans la demande de brevet européen EP 0452031. L'inconvénient de cette méthode est qu'elle dégrade les performances de bruit de phase d'un synthétiseur numérique direct du fait notamment de l'injection de bruit et de la difficulté d'apparier les deux CNA.

Le but de l'invention est notamment d'améliorer la pureté spectrale des synthétiseurs numériques directs en réduisant le niveau des raies parasites, et cela sans dégrader les performances de bruit. A cet effet, l'invention a pour objet un dispositif de génération de signaux analogiques selon la revendication 1.

L'invention a pour principaux avantages qu'elle minimise l'augmentation du plancher de bruit de phase d'un synthétiseur numérique, qu'elle s'adapte à tous types de systèmes de génération de signaux analogiques à partir de convertisseurs analogique-numérique, qu'elle est peu encombrante, qu'elle est simple à mettre en oeuvre et qu'elle est économique.

D'autres caractéristiques et avantages de l'invention apparaîtront à l'aide de la description qui suit faite en regard de dessins annexés qui représentent:

- la figure 1, par un synoptique, un exemple de réalisation d'un dispositif selon l'art antérieur ;
- la figure 2, par un synoptique, un exemple de réalisation possible d'un dispositif selon l'invention ;
- les figures 3 à 6, une illustration dans le domaine fréquentiel, du rôle d'un modulateur sigma-delta dans un dispositif selon l'invention ;
- la figure 7, par un synoptique, un exemple de modulateur sigma-delta implanté dans un dispositif selon l'invention.

L'invention est décrite relativement à un synthétiseur numérique direct, elle peut néanmoins s'appliquer à d'autres type de dispositifs de génération de signaux à partir de données numériques.

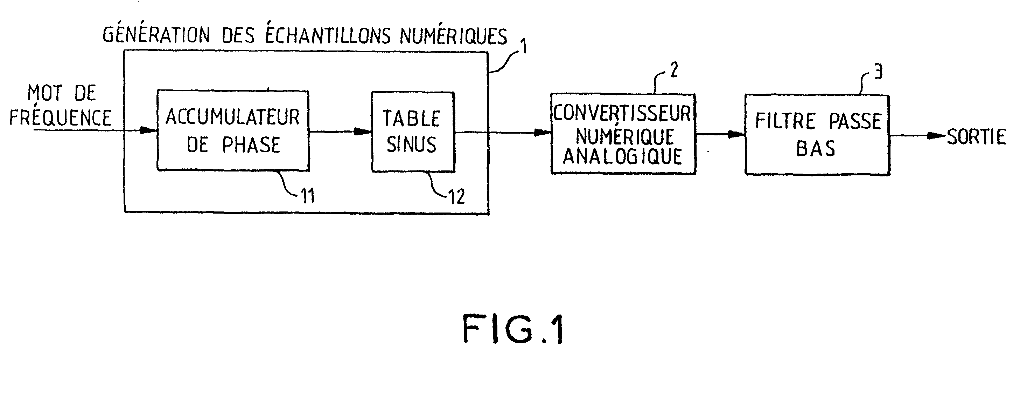

La figure 1 représente par un synoptique, un synthétiseur numérique direct selon l'art antérieur. Ce synthétiseur comporte par exemple trois bloc principaux 1, 2, 3. Un bloc 1 de génération d'échantillons numériques du signal sinusoïdal à synthétiser reçoit un mot numérique de commande de la fréquence et un signal d'horloge. Classiquement, ce bloc 1 comporte un accumulateur de phase 11 et une mémoire 12 contenant la fonction sinus. L'accumulateur de phase 11 comporte par exemple un générateur de rampes numérisées reliées au bus d'adresses de la mémoire 12 de la fonction sinus. La sortie de ce premier bloc 1 est reliée à l'entrée d'un bloc 2 de conversion des échantillons numériques délivrés par ce premier bloc 1 en un signal analogique. Le CNA est contenu dans ce bloc 2 ou le constitue. La sortie de ce deuxième bloc 2 est reliée à l'entrée d'un bloc 3 de filtrage passe-bas qui permet par exemple d'éliminer les composantes spectrales liées à l'échantillonnage. Ce troisième bloc 3 délivre le signal analogique de sortie du synthétiseur. Comme cela a été indiqué précédemment, un inconvénient majeur de ce synthétiseur numérique direct est que le spectre du signal de sortie présente de nombreuses raies parasites. Celles-ci sont notamment dues à deux causes principales, qui concernent le processus de conversion numérique-analogique, décrites précédemment. Une première cause est la quantification de l'amplitude et une deuxième cause est la non-linéarité du CNA utilisé.

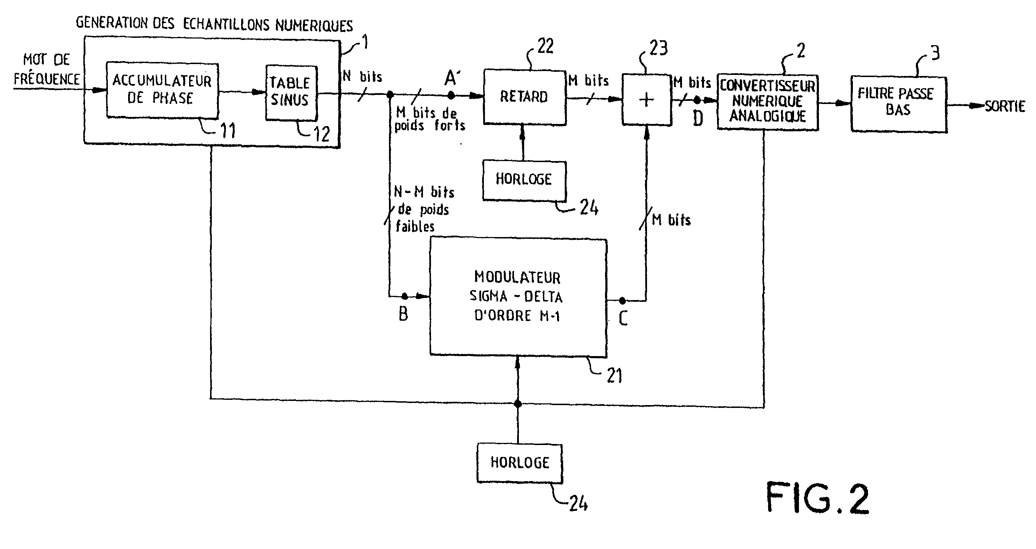

La figure 2 présente par un synoptique un synthétiseur numérique direct selon l'invention. Un modulateur 21 sigma-delta est intercalé entre le bloc 1 de génération des échantillons numériques ou de génération des mots à convertir, et le bloc 2 de conversion numérique-analogique. L'utilisation d'un tel modulateur est connue pour passer d'un mot de N bits à un mot de M bits, M étant inférieur à N, en éliminant l'erreur de troncature dans la bande des signaux utiles, qui est la bande dans laquelle la sinusoïde ou un autre signal est synthétisé. Les composantes spectrales liées à cette troncature sont ensuite rejetées hors de cette bande. Selon l'invention, un modulateur sigma-delta, d'ordre élevé, est utilisé de façon à non seulement annuler l'erreur de quantification, mais également réduire dans de fortes proportions les effets de non-linéarité du CNA. Ainsi, selon l'invention, le modulateur sigma-delta est utilisé avant tout pour résoudre le problème de non-linéarité, et avantageusement il élimine en plus les erreurs de troncature.

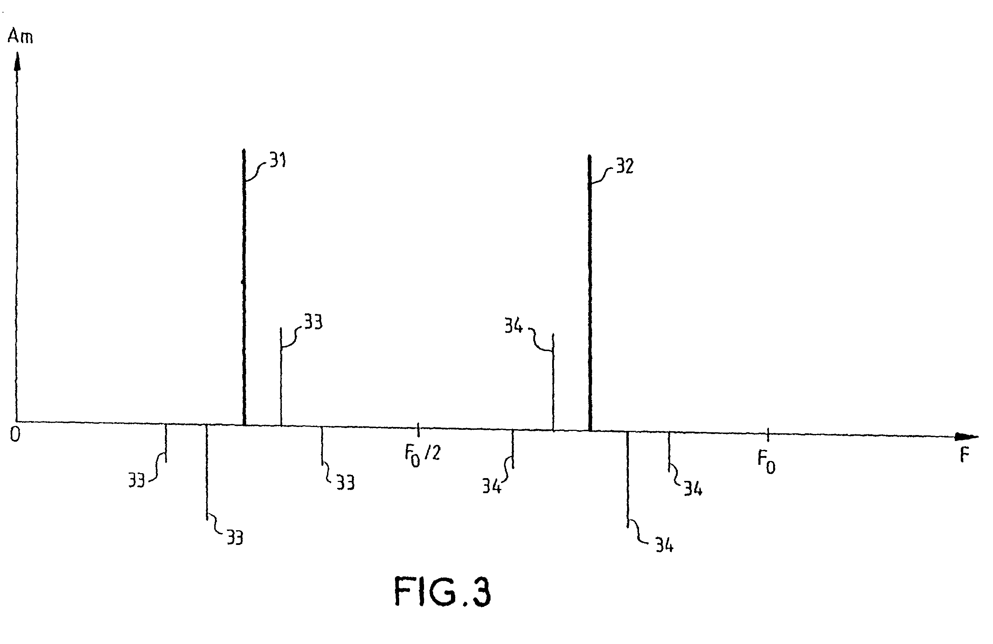

A la sortie du premier bloc 1, le bus est séparé en M bits de poids forts qui entrent par exemple dans un module de retard 22, et en N-M bits de poids faibles qui entrent dans le modulateur sigma-delta 21. La sortie de ce modulateur est un bus de M bits qui est additionné aux M bits de sortie du module de retard 22 par des moyens 23 d'addition numérique. Le retard créé par le module de retard 22 correspond au temps de traitement d'un mot par le modulateur sigma-delta, entre son entrée et sa sortie. Le résultat de l'addition constitue le signal d'entrée du convertisseur numérique-analogique 2. Le filtre passe-bas 3 connecté par exemple à la sortie de ce dernier élimine les composantes spectrales liées à l'échantillonnage ainsi que celles générées par le modulateur sigma-delta 21. Le signal d'entrée de ce dernier est l'erreur ε commise en tronquant le mot de N bits à M bits. Une horloge 24 fournit par exemple un signal d'horloge de fréquence $F_0$ commun au modulateur 21, au convertisseur analogique-numérique 2 et au module de retard 22. Les figures 3 à 6 qui suivent illustrent le rôle du modulateur sigma-delta. Elles représentent les amplitudes des raies des signaux numériques en jeu en fonction de la fréquence F. En ce qui concerne le modulateur sigma-delta, le nombre de bits M en sortie du modulateur n'est pas lié au nombre de bits tronqués N-M. Ceci vient notamment du fait que l'invention utilise seulement des modulateurs sigma-delta qui génèrent des débordements. C'est notamment ce mécanisme de débordement qui permet de résoudre le problème de la non-linéarité du convertisseur numérique-analogique.

La figure 3 illustre le spectre du signal en un point A situé à l'entrée du module de retard 22. Plus précisément, elle représente les amplitude Am des composantes spectrales du signal en fonction de la fréquence F dans un intervalle compris entre la fréquence nulle o et la fréquence d'horloge $F_0$. Ce signal comprend les M bits de poids les plus fort du mot à convertir. Il comporte par exemple deux raies utiles 31, 32 correspondant au signal à synthétiser. En fait, une raie 31 est la raie utile et l'autre raie 32 est la raie utile repliée, du fait de l'échantillonnage. Ces raies sont symétriques par rapport à la moitié de la fréquence d'horloge $F_0$. Des raies parasites 33, 34 correspondent à la troncature du signal numérique ou mot à convertir, cette troncature correspondant aux N-M bits de poids faible du signal.

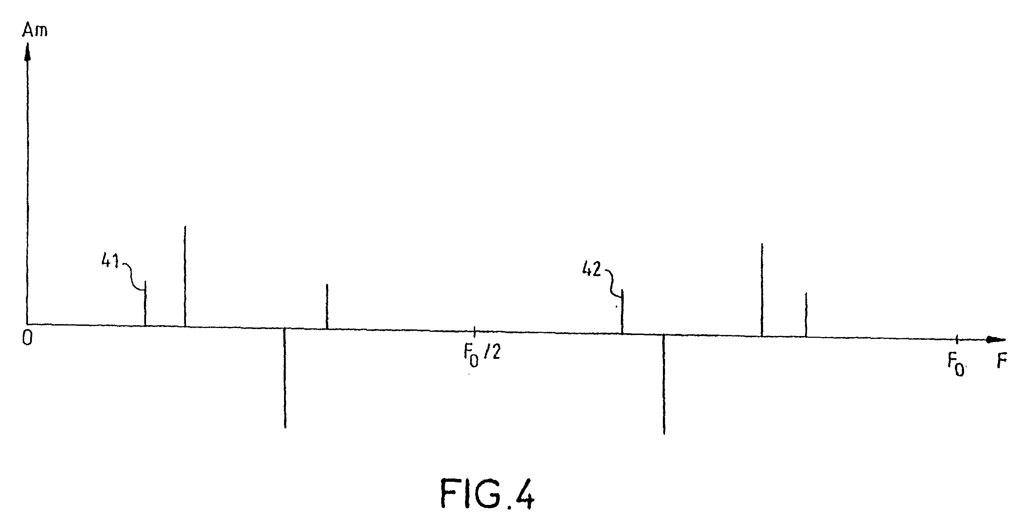

La figure 4 illustre le spectre du signal en un point B situé à l'entrée du modulateur sigma-delta 21. Ce signal comporte les N-M bits de poids faible du mot à convertir. Les raies 41, 42 de ce signal ont les mêmes amplitudes que les raies parasites 33, 34 du signal à l'entrée A du module de retard 22, elles sont opposées et situées aux mêmes fréquences.

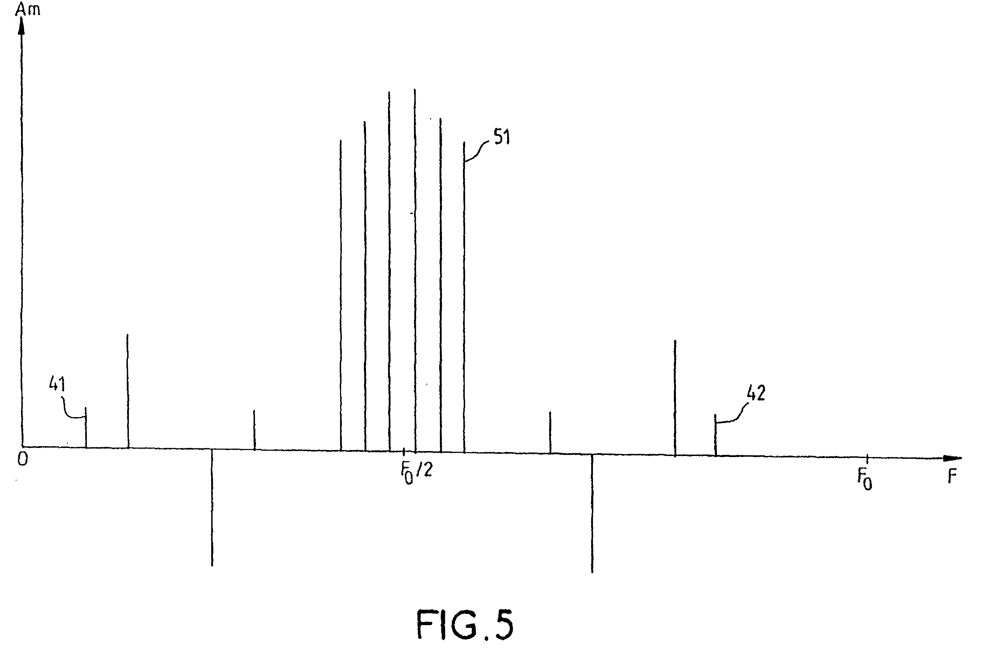

La figure 5 illustre le spectre du signal en un point C situé en sortie du modulateur sigma-delta 21. La sortie de ce dernier est par exemple élaborée de façon à ce qu'elle comporte le même nombre de bits que le signal à l'entrée A du module de retard 22 et que son expression soit la somme de l'erreur ε précitée avec un signal numérique décorrélé du signal à synthétiser ou à générer, c'est-à-dire en fait décorrélé du mot tronqué, représenté par les raies utiles 31, 32 sur la figure 3. Aux raies 41, 42 du signal d'erreur ε sont donc ajoutées des raies 51 décorrélés du signal utile et de ce signal d'erreur ε. Le terme décorrélé signifie notamment qu'aucune fonction de corrélation n'existe entre les signaux.

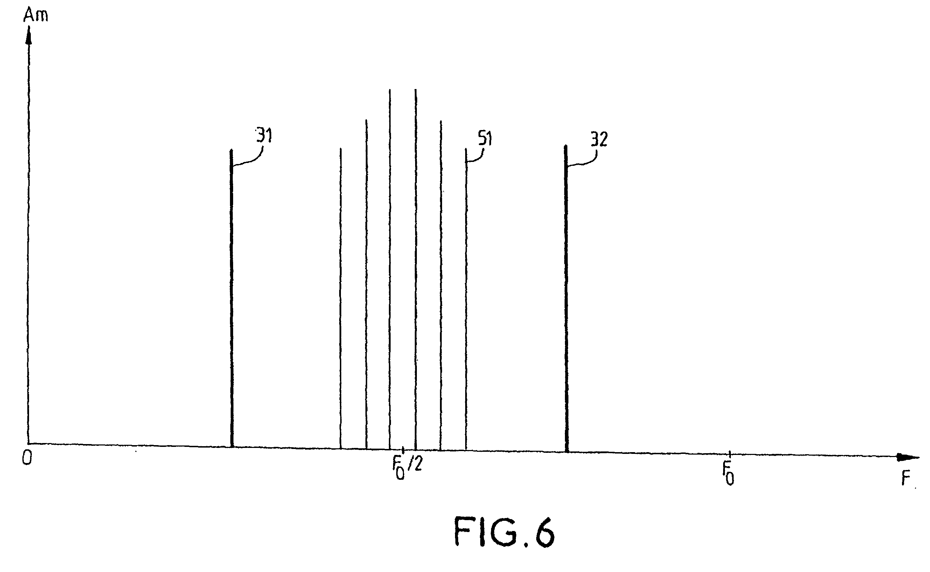

La figure 6 illustre le spectre du signal en un point D situé à l'entrée du convertisseur numérique-analogique, donc après l'addition des signaux issus du module à retard 22 et du modulateur sigma-delta. Les raies 41, 42 du signal d'erreur s'annulent avec les raies parasites 33, 34 du signal à l'entrée A du module de retard 22. Les raies 51 du signal décorrélé subsistent en présence des raies utiles 31, 32. Le signal 51 est situé dans le domaine spectral hors de la bande où les signaux utiles 31, 32 sont synthétisés, ce qui permet d'éliminer ce signal 51 par un filtrage après la conversion numérique-analogique, par exemple par le filtre passe-bas 3 en sortie du convertisseur numérique-analogique 2.

De préférence, l'amplitude du signal décorrélé 51 est voisine de celle du signal utile à synthétiser, elle peut même être supérieure à celle du signal utile. Ainsi, pour une valeur donnée du mot de sortie du bloc 1 de génération des échantillons numériques, le signal à l'entrée du convertisseur numérique-analogique 2 occupe une grande partie de la plage de fonctionnement de ce dernier, ce qui permet de lisser ses défauts de non-linéarité et donc de réduire de façon significative les raies parasites dues à ces défauts, et cela tout en supprimant le bruit de quantification correspondant à la troncature du signal de N à M bits. Le problème de la quantification d'amplitude et le problème de la non-linéarité du convertisseur numérique-analogique sont donc résolus de façon concomitante par le dispositif selon l'invention, et cela sans introduction de bruit.

En effet, dans un mode de réalisation préférentiel, le signal de sortie du modulateur 21 s'exprime au moyen d'une équation sur les transformées en z, la transformée en z S(z) du signal étant par exemple donnée par la relation suivante :

$$S(z) = z^{-\alpha}\, \varepsilon(z) - Q(1-z^{-1})^{\beta} \qquad (1)$$

$z^{-\alpha}$ représente un retard qui est compensé par le module de retard 22, $\beta$ désigne l'ordre du modulateur sigma-delta 21. De préférence cet ordre est élevé, par exemple égal à M-1, où M est le nombre de bits du convertisseur analogique-numérique 2. Un modulateur d'ordre élevé permet notamment de rendre linéaire le convertisseur analogique-numérique en délivrant un signal dont l'énergie balaie au moins la moitié de la plage de ce convertisseur. $\varepsilon(z)$ représente la transformée en z du signal d'erreur.

Le terme $Q(1-z^{-1})^{\beta}$ représente le signal décorrélé 51 précité. Ce signal est par exemple situé dans le domaine spectral autour de la fréquence $F_0 / 2$ où $F_0$ est la fréquence du signal d'horloge 24. Il est donc situé à un endroit du spectre où la synthèse d'un signal de fréquence $F_X$ est en général sans intérêt à cause de la difficulté de filtrage de la fréquence repliée par échantillonnage qui est égale à $F_0 - F_X$.

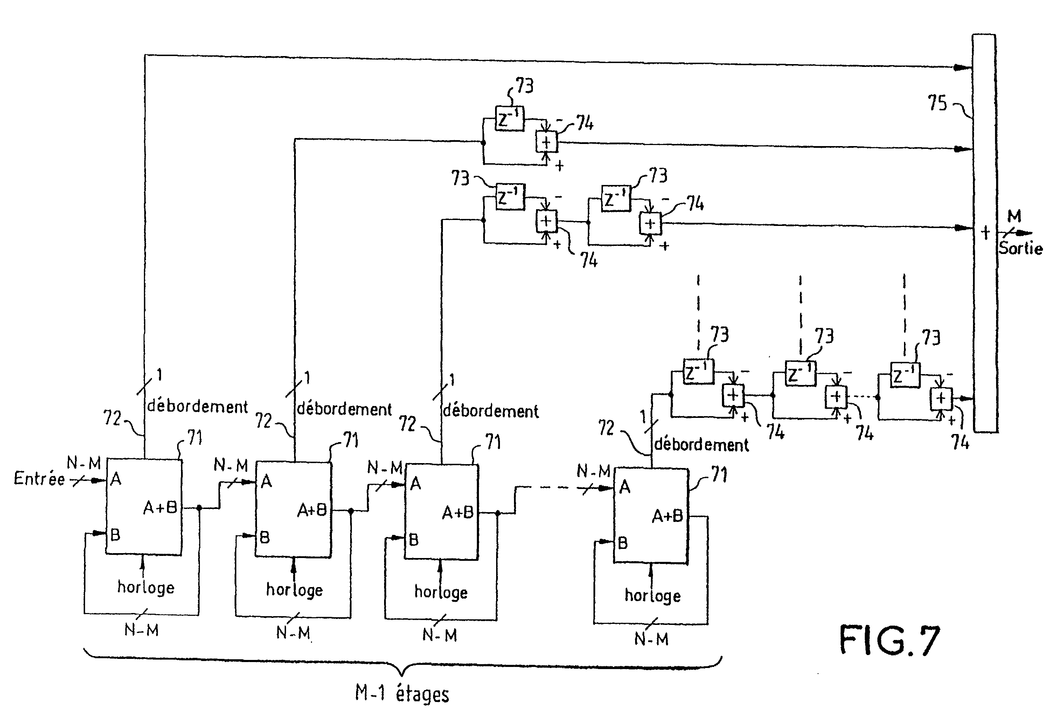

La figure 7 illustre par un synoptique un exemple de modulateur sigma-delta 21 pouvant être implanté dans un dispositif selon l'invention. Avec le mécanisme de débordement, le bit de poids faible du bus de sortie du modulateur sigma-delta 21 a le même poids que le bus de poids faible du bus de M bits obtenu après troncature. L'addition de la sortie du modulateur 21 avec le bus de M bits doit se faire en faisant correspondre les bits de poids faible. C'est la seule contrainte. Ainsi, si le bus en sortie du modulateur est de M bits, l'addition avec le bus de M bits, résultant de la troncature du mot de N bits, donne au plus un bus de M+1 bits. En fait, le résultat de l'addition 23 peut être un bus de M bits en tenant compte, dans le bus de N bits de départ, du fait qu'il y aura une addition, les amplitudes étant gérées dans le bus de N bits pour que l'addition se fasse sans débordement.

Le modulateur sigma-delta 21 est mot de N-M bits. Le rôle général d'un modulateur sigma-delta est d'effectuer un codage de ce signal d'entrée de telle sorte que l'erreur de quantification, ou signal décorrélé mentionné précédemment, créée par le modulateur est mise en forme, c'est-à-dire que les composantes spectrales liées à cette erreur de quantification sont situées en dehors de la bande des signaux utiles. Dans l'invention, un type particulier de modulateur sigma-delta est utilisé, qui génère des débordements. De façon originale, selon l'invention, on exagère au maximum ce phénomène de débordement en prenant un ordre élevé pour le modulateur sigma-delta, égal à M-1 dans un mode de réalisation préférentiel. Le fait d'exagérer le phénomène de débordement fait que la puissance de l'erreur de quantification précitée est très supérieure à la puissance du signal d'entrée du modulateur sigma-delta, de telle sorte par exemple que l'amplitude du signal décorrélé 51 soit par exemple supérieure à celle du signal utile. Ce mode de fonctionnement n'est ni naturel ni usuel. C'est notamment cette forte erreur de quantification qui permet de linéariser le convertisseur numérique-analogique.

Le modulateur sigma-delta 21 selon la figure 7 est par exemple composé de M-1 étages d'accumulation 71 qui sont connectés en cascade, c'est à dire que l'entrée de l'étage d'ordre P est la sortie de l'étage P-1. Le nombre d'étages du modulateur correspond à son ordre. Chaque étage d'accumulation 71 possède une sortie 72 de débordement. Ces dernières sont combinées entre elles par un additionneur 75, via des étages de différentiation 73, 74, pour donner le signal de sortie du modulateur sigma-delta 21 codé sur M bits. Un étage de différentiation comporte un élément de retard 73 et un élément soustracteur 74. L'élément de retard 73, par exemple à base de bascules D, a notamment pour fonction de permettre la synchronisation des opérations à l'intérieur du modulateur 21.. L'entrée d'un étage de différentiation attaque l'entrée de l'élément de retard 73 et l'entrée positive de l'élément soustracteur 74. La sortie de l'élément de retard attaque l'entrée négative de l'élément soustracteur, qui retranche le signal retardé au signal d'entrée. Un étage d'accumulation 71 comporte une première entrée A et une deuxième entrée B codées sur N-M bits et une sortie A+B codée sur N-M bits qui présente l'addition des deux entrées A, B. Cette sortie attaque à la fois la première entrée A de l'étage suivant et la deuxième sortie B de son étage par rebouclage. L'entrée du modulateur est la première entrée A du premier étage. Pour chaque étage, le bit de débordement 72 de l'addition A+B attaque l'entrée d'un premier étage de différentiation 73, 74 d'une chaîne de P-1 étages de différentiation, P étant l'ordre de l'étage d'accumulation 71. Le additionneur 75 additionne les sorties de toutes les chaînes. Le bit de débordement du premier étage d'accumulation attaque directement le additionneur 75. La sortie du premier étage de différentiation d'une chaîne est -1, 0 ou +1. Chaque étage de différentiation 73,74 peut doubler la valeur de son entrée. Pour prendre alors en compte, les valeurs maximum possible, la sortie du additionneur 75 est codée sur M bits.

Le signal de sortie d'un modulateur tel qu'illustré par la figure 7 a une amplitude comprise entre :

$$-2^{M-2}+1 \text{ et } 2^{M-2}$$

Le signal en sortie du bloc 1 de génération des échantillons numériques est quant à lui codé sur N bit avec une amplitude qui est notamment déterminée de façon à ce qu'il n'y ait pas de débordement lors de son addition 23 avec le signal de sortie du modulateur 21. A cet effet, le signal en sortie du bloc 1 de génération des échantillons a une amplitude par exemple comprise entre :

$$2^{N-2} - 2^{N-M} \text{ et } 3 \times 2^{N-2} - 2^{N-M}$$

L'invention permet de minimiser l'augmentation du plancher de bruit d'un synthétiseur dans la bande des signaux utiles. En effet, l'augmentation du bruit est seulement due à l'étalement de l'énergie de non linéarité du convertisseur numérique-analogique dans cette bande, l'énergie de quantification ne contribuant pas à cette augmentation puisque l'effet de la quantification est supprimé lors de l'addition du signal de sortie du bloc 1 de génération des échantillons numérique et du signal de sortie du modulateur sigma-delta 21. Pour que l'étalement se réalise bien, il est préférable que la période du signal décorrélé 51 soit suffisamment longue, cette période dépendant notamment de la période de la séquence du mot de N bits délivré par le bloc 1 de génération des échantillons numériques.

L'invention s'adapte à tous types de systèmes de génération de signaux analogiques à partir de convertisseurs analogique-numérique, que ces signaux soient sinusoïdaux ou non. Elle est simple à mettre en oeuvre dans la mesure où elle ne nécessite que le câblage de quelques éléments supplémentaires dont notamment le modulateur sigma-delta. Pour les mêmes raisons, elle est peu encombrante et économique, les composants utilisés étant par ailleurs de faible coût.

## Revendications

1.  Dispositif de génération de signaux analogiques **caractérisé en ce que** comportant un bloc (1) de génération de mots codés sur N bits et un convertisseur numérique-analogique (2) dont l'entrée est codée sur M bits, M étant inférieur à N, il comporte par ailleurs un modulateur sigma-delta à débordements (21), à la sortie du bloc (1) le bus étant séparé en M bits de poids forts codant un signal utile et en N-M bits de poids faible constituant l'erreur de troncature ($\varepsilon$), les N-M bits de poids faible entrant dans le modulateur sigma-delta (21), la sortie de ce modulateur étant additionnée au signal utile par des moyens (23) d'addition numérique, le résultat de l'addition constituant le signal d'entrée du convertisseur numérique-analogique (2), l'ordre du modulateur étant élevé de façon à ce que l'amplitude du signal de sortie du modulateur soit voisine ou supérieure à celle du signal utile.

2.  Dispositif selon la revendication 1, **caractérisé en ce que** l'expression du signal de sortie du modulateur sigma-delta (21) étant la somme de l'erreur de troncature ($\varepsilon$, 41, 42), réalisée en tronquant un mot, avec un signal numérique décorrélé (51) de ce mot, un filtre passe-bas (3) est connecté en sortie du convertisseur numérique-analogique, ce filtre éliminant le signal numérique décorrélé (51).

3.  Dispositif selon l'une quelconque des revendications précédentes, **caractérisé en ce que** l'ordre du modulateur sigma-delta (21) est égal à M-1.

4.  Dispositif selon l'une quelconque des revendications précédentes, **caractérisé en ce qu'**un module de retard (22) est intercalé entre le bloc (1) de génération des mots et les moyens d'addition (23), le retard créé par ce module (22) correspondant sensiblement au temps de traitement d'un mot par le modulateur sigma-delta (21) entre son entrée et sa sortie.

5.  Dispositif selon l'une quelconque des revendications 2 à 4, **caractérisé en ce que** l'amplitude du signal numérique décorrélé (51) est voisine de celle d'un mot.

6.  Dispositif selon l'une quelconque des revendications précédentes, **caractérisé en ce qu'**il constitue un synthétiseur numérique direct.

## Patentansprüche

1.  Vorrichtung zur Erzeugung analoger Signale, **dadurch gekennzeichnet, daß** sie einen Block (1) zur Erzeugung von über N Bits kodierten Wörtern und einen Digital/-Analogwandler (2), dessen Eingang über M Bits kodiert ist, wobei M<N gilt, sowie weiter einen $\Sigma\ddot{\text{A}}$-Modulator (21) mit Überträgen am Ausgang des Blocks (1) aufweist, wobei jedes Wort in M Bits hoher Wichtung, die ein Nutzsignal kodieren, und in N-M Bits geringer Wichtung unterteilt ist, die den Rundungsfehler (å) bilden und an den Eingang des $\Sigma\ddot{\text{A}}$-Modulators (21) gelangen, während das Ausgangssignal diese Modulators zum Nutzsignal über digitale Addiermittel (23) addiert wird und das Ergebnis der Addition das Eingangssignal des Digital/Analogwandlers (2) bildet, wobei die Ordnung des Modulators hoch ist, sodaß die Amplitude des Ausgangssignal des Modulators in der Nähe der Amplitude des Nutzsignals oder darüber liegt.

2.  Vorrichtung nach Anspruch 1, **dadurch gekennzeichnet, daß**, da der Wert des Ausgangssignals des $\Sigma\ddot{\text{A}}$-Modulators (21) die Summe des Rundungsfehlers (å, 41, 42), der beim Abrunden eines Wortes entsteht, mit einem dekorrelierten digitalen Signal (51) dieses selben Wortes ist, ein Tiefpaßfilter (3) an den Ausgang des Digital/Analogwandlers zur Beseitigung des dekorrelierten digitalen Signals (51) angeschlossen ist.

3. Vorrichtung nach einem beliebigen der vorstehenden Ansprüche, **dadurch gekennzeichnet, daß** die Ordnung des ΣÄ-Modulators (21) den Wert M-1 hat.

4. Vorrichtung nach einem beliebigen der vorstehenden Ansprüche, **dadurch gekennzeichnet, daß** ein Verzögerungsmodul (22) zwischen dem Block (1) zur Erzeugung der Wörter und den Addiermitteln (23) eingefügt ist, dessen Verzögerungszeit im wesentlichen der Verarbeitungdauer des Wortes durch den ΣÄ-Modulator (21) zwischen dessen Eingang und dessen Ausgang entspricht.

5. Vorrichtung nach einem beliebigen der Ansprüche 2 bis 4, **dadurch gekennzeichnet, daß** die Amplitude des dekorrelierten digitalen Signals (51) in der Nähe der eines Wortes liegt.

6. Vorrichtung nach einem beliebigen der vorstehenden Ansprüche, **dadurch gekennzeichnet, daß** sie einen direkten digitalen Synthetisierer bildet.

**Claims**

1. Device for generating analog signals, **characterized in that** comprising a block (1) for generating words coded on N bits and a digital/analog converter (2) the input of which is coded on M bits, M being less than N, it moreover comprises a sigma-delta modulator with overflows (21), at the output of the block (1) the bus being separated into M most significant bits coding a useful signal and into N-M least significant bits constituting the truncation error (ε), the N-M least significant bits entering the sigma-delta modulator (21), the output of this modulator being added to the useful signal by means (23) of numerical addition, the result of the addition constituting the input signal for the digital/analog converter (2), the order of the modulator being high so that the amplitude of the output signal from the modulator is close to or greater than that of the useful signal.

2. Device according to Claim 1, **characterized in that** the expression for the output signal from the sigma-delta modulator (21) being the sum of the truncation error (ε, 41, 42), produced by truncating a word, with a digital signal decorrelated (51) from this word, a low-pass filter (3) is connected at the output of the digital/analog converter, this filter eliminating the decorrelated digital signal (51).

3. Device according to any one of the preceding claims, **characterized in that** the order of the sigma-delta modulator (21) is equal to M-1.

4. Device according to any one of the preceding claims, **characterized in that** a delay module (22) is interposed between the block (1) for generating words and the means of addition (23), the delay created by this module (22) corresponding substantially to the processing time of a word by the sigma-delta modulator (21) between its input and its output.

5. Device according to any one of Claims 2 to 4, **characterized in that** the amplitude of the decorrelated digital signal (51) is close to that of a word.

6. Device according to any one of the preceding claims, **characterized in that** it constitutes a direct digital synthesizer.

GÉNÉRATION DES ÉCHANTILLONS NUMÉRIQUES 1

MOT DE
FRÉQUENCE

| ACCUMULATEUR DE PHASE 11 | TABLE SINUS 12 |

CONVERTISSEUR NUMÉRIQUE ANALOGIQUE 2

FILTRE PASSE BAS 3

SORTIE

FIG.1

EP 0 887 941 B1

FIG.2

GENERATION DES ECHANTILLONS NUMERIQUES

MOT DE FRÉQUENCE

ACCUMULATEUR DE PHASE — 11

TABLE SINUS — 12

1

N bits

A'

M bits de poids forts

N-M bits de poids faibles

B

RETARD 22

M bits

HORLOGE 24

MODULATEUR SIGMA - DELTA D'ORDRE M-1 — 21

C

M bits

+ 23

M bits

D

CONVERTISSEUR NUMERIQUE ANALOGIQUE 2

FILTRE PASSE BAS 3

SORTIE

HORLOGE 24

EP 0 887 941 B1

FIG.3

EP 0 887 941 B1

FIG.4

EP 0 887 941 B1

FIG.5

FIG.6

EP 0 887 941 B1

FIG.7

13